# EUROPEAN PATENT SPECIFICATION

(11) **EP 3 358 636 B1**
(45) Date of publication and mention of the grant of the patent: **17.08.2022**
(21) Application number: 16850664.0
(22) Date of filing: 27.09.2016
(51) Int. Cl.: H01L 51/42

(54) **PHOTOELECTRIC CONVERSION ELEMENT**
ELEMENT ZUR PHOTOELEKTRISCHEN UMWANDLUNG
ÉLÉMENT DE CONVERSION PHOTOÉLECTRIQUE

(30) Priority: 28.09.2015 JP 2015190362
(43) Date of publication of application: 08.08.2018
(73) Proprietor: National University Corporation Nagoya University, Nagoya-shi, Aichi 464-8601 (JP); Nisshinbo Holdings Inc., Tokyo 103-8650 (JP)
(72) Inventor: AWAGA, Kunio, Nagoya-shi Aichi 464-8601 (JP); DALGLEISH, Simon, Nagoya-shi Aichi 464-8601 (JP); REISSIG, Louisa, Nagoya-shi Aichi 464-8601 (JP); YUYAMA, Kanako, Chiba-shi Chiba 267-0056 (JP)
(74) Representative: TBK
(86) International application number: PCT/JP2016/004356
(87) International publication number: WO 2017/056485

(56) References cited:
- EP-A1- 2 445 051
- EP-A1- 2 461 420
- JP-A- H0 563 255
- JP-A- H0 563 255
- JP-A- H0 794 690
- KR-B1- 101 539 959
- US-A1- 2014 054 442
- US-A1- 2015 048 279

## Description

### TECHNICAL FIELD

The present invention relates to a photoelectric conversion element converting light energy into electric energy.

### BACKGROUND ART

For example, Patent Literature No. 1 discloses an example of the conventional technologies for the purpose of providing a photoelectric conversion element with satisfactory photoelectric conversion efficiency and good optical response characteristics. The photoelectric conversion element comprises a photoelectric conversion layer including a charge-separated layer and a polarized layer. The charge-separated layer contains a semiconductor material in which the electron mobility and hole mobility differ on another, and a dopant having electron conductivity. The polarized layer is formed of an ionic liquid whose major components include a combination of a positive ion and negative ion. Further prior art can be found in document US 2014/0 054 442 A1 describing a nanocomposite photodetector, in document JP H05 63255 A describing an organic optical element as well as in document KR 101 539 959 B1 describing a method for manufacturing of organic photovoltaics.

### Related Technical Literature

### Patent Literature

Patent Literature No. 1: Japanese Unexamined Patent Publication (KOKAI) Gazette No. 2013-218924

### Non-patent Literature

Non-patent Literature No.1: Ji Yu, Chong-Xin Shan, Qian Qiao, Xiu-Hua Xie, Shuang-Peng Wang, Zhen-Zhong Zhang and De-Zhen Shen, Enhanced Responsivity of Photodetectors Realized via Impact Ionization, Sensors, 12, 1280-1287 (2012)
Non-patent Literature No. 2: Ghusoon M Ali and P Chakrabarti, ZnO-based interdigitated MSM and MISIM ultraviolet photodetectors, JOURNAL OF PHYSICS (2010)
Non-patent Literature No. 3: W J Wang, C X Shan, H Zhu, F Y Ma, D Z Shen, X W Fan and K L Choy, Metal-insulator-semiconductor-insulator-metal structured titanium dioxide ultraviolet photodetector, JOURNAL OF PHYSICS (2009)
US 2014/054442 A1 , JP H05 63255 A and KR 101 539 959 B1 disclose photoelectric conversion elements comprising insulating buffer layers between the electrodes.

### SUMMARY OF THE INVENTION

### Assignment to be Solved by the Invention

However, conventional photoelectric conversion elements, to which the technologies disclosed in Patent Literature No. 1 and Non-patent Literature Nos. 1 through 3 are applied, have been associated with the following problems. First, the capacitance of the polarized layer can be enlarged in order to make a current flowing within a system, but the enlarging time constant makes it difficult to carry out a high-speed response. Second, the capacitance of the polarized layer can be made smaller in order to deal with a fast response, but a current flowing within a system becomes smaller as the capacitance becomes smaller. That is, a current intensity and a response speed have been in a contradicting relationship.

The present invention has been made in view of the issues as described above. It is therefore an object of the present invention to provide a photoelectric conversion element which is upgraded more in both of the current intensity and response speed than those of its conventional predecessors.

### Means for Solving the Assignment

A first subject matter according to the present invention, which is made in order to solve the aforementioned problems, comprises a photoelectric conversion element according to claim 1.

The first subject matter constructed as described above comprises the first insulator having a larger capacitance (i.e., the first capacitance). Accordingly, due to a photoexcited charge separation and polarization in the intermediate layer of the organic semiconductor, the first insulator is also polarized greatly. The polarized first insulator makes a large electric field in the organic-semiconductor intermediate layer. Consequently, the charge separation is further facilitated in the organic-semiconductor intermediate layer. The synergic effect of these makes a polarization current larger within an entire circuit. Moreover, the second insulator having a smaller capacitance (i.e., the second capacitance) quickens the first subject matter in the response speed. Therefore, the first subject matter upgrades a photoelectric conversion element more in both of the current intensity and response speed than those of its conventional predecessors.

The subject matter according to claim 1 makes a large current flow in a photoelectric conversion element because the first insulator has a larger capacitance than does the second insulator. Therefore, the subject matter securely upgrades a photoelectric conversion element more in the current intensity than that of its conventional predecessors.

A second subject matter according to the present invention features that the second insulator includes an ionic liquid.

A third subject matter according to the present invention features that the organic semiconductor includes a fine-particle-shaped electric conductor intermixed in a predetermined proportion.

The third subject matter constructed as described above makes the organic semiconductor, in which a fine-particle-shaped conductor is intermixed, exhibit a decreased electric resistance and enhanced response characteristics. Therefore, the third subject matter further upgrades the responsive speed of a photoelectric conversion element.

A fourth subject matter according to the present invention features that the light is at least one member selected from the group consisting of pulsed lights, chopped lights and modulated lights.

The fourth subject matter constructed as described above makes a photoelectric conversion element exhibit a strengthened current intensity and quickened responsive speed even to lights whose light intensity is modulated.

Note herein that the "current" flowing in a conductive wire connecting between the first electrode and the second electrode is mainly a transient current. The "organic semiconductor" is a semiconductor formed of an organic material which receives a light to be able to separate a charge (also referred to as "carriers"). An arbitrary or discretionary material is applicable to the organic material. The organic semiconductor is constructed satisfactorily to directly receive a light. Alternatively, when the electrodes or insulators are formed of a transparent material, the organic semiconductor is constructed properly to indirectly receive a light. On the other hand, when the electrodes or insulators are formed of an opaque material, they are formed satisfactorily in a thickness through which a light is reachable to the organic semiconductor; namely, they are formed properly of a thin film. Both of the "first insulator" and "second insulator" comprise an arbitrary or discretionary substance as far as the dielectric property is superior to the electric conductive property in the substance. The "first insulator" even comprises satisfactorily an ionic liquid which includes a positive ion and negative ion as the major components. Both of the paired electrodes, namely, both of the first and second electrodes, are used so as to change the polarities one another like electrodes in an alternating-current source. The term, "contact," involves joining, and implies forms in which polarization is conveyed from one member to another member via the contact face between them. The "ionic liquid" comprises satisfactorily either a liquid or a gel in so far as the liquid or gel includes a positive ion and negative ion as the major components. The term, "current intensity, " is also referred to as a current magnitude. The phrase, "being intermingled or intermixed," involves "doping."

### BRIEF DESCRIPTION OF THE DRAWINGS

Fig. 1 is a cross-sectional view schematically illustrating First Embodiment of a photoelectric conversion element according to the present invention;
Fig. 2 is a schematic diagram illustrating an operating principle of the photoelectric conversion element;
Fig. 3 is a circuit diagram for measuring characteristics of First Embodiment;
Fig. 4 is a graphic diagram showing the characteristics of First Embodiment;
Fig. 5 is a cross-sectional view schematically illustrating Second Embodiment of a photoelectric conversion element according to the present invention;
Fig. 6 is a graphic diagram showing characteristics of Second Embodiment; and
Fig. 7 is a cross-sectional view schematically illustrating Third Embodiment of a photoelectric conversion element according to the present invention.

### MODE FOR CARRYING OUT THE INVENTION

Forms for executing or implementing the present invention will be hereinafter described based on the drawings . Note that, unless otherwise specified explicitly, the word, "connect," means to electrically connect members with each other when it is used. The respective drawings illustrate elements needed for describing the present invention, but do not necessarily illustrate all of the actual elements. When referring to directions, such as up, down, right and left, they are based on notes or designations implied or illustrate in the drawings.

### (First Embodiment)

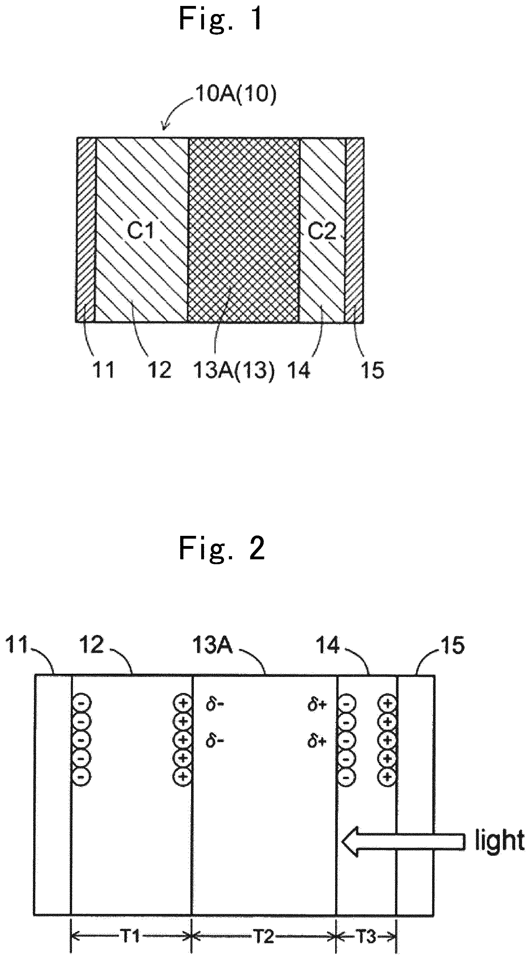

First Embodiment will be hereinafter described with reference to Figs. 1 through 4. A photoelectric conversion element 10A is one of the examples or variations of a photoelectric conversion element 10. The photoelectric conversion element 10A comprises a first electrode 11, a first insulator 12, an organic semiconductor 13A, a second insulator 14, and a second electrode 15.

The first electrode 11 and second electrode 15 correspond to the claimed "a pair of electrodes." It is not necessarily needed to use a transparent electrode, which exhibits optical transparency, for the first electrode 11 and second electrode 15 as far as they have an elemental structure capable of optically exciting the organic semiconductor 13A directly. However, when exciting the organic semiconductor 13A by way of one of the electrodes, the electrode is required to exhibit transparency. The following are exemplary materials for transparent electrically conducting member: tin oxide with antimony or fluorine doped, such as ATO or FTO; and electrically conducting metallic oxides, such as tin oxide, zinc oxide, indium oxide, indium tin oxide (or ITO) and indium zinc oxide (or IZO). The first electrode 11 and second electrode 15 can even be a thin film made of metal, such as gold, silver, chromium or nickel. The first electrode 11 and second electrode 15 may also be made of a thin film including a mixture of an electric conducting metallic oxide and metal, or a laminated member including thin films made of an electric conducting metallic oxide and metal. The first electrode 11 and second electrode 15 can even be made of an inorganic electrically conducting substance, such as copper iodide or copper sulfide. The first electrode 11 and second electrode 15 may also be made of an organic electrically conducting substance, such as carbon nanotube, polypyrrole, polyaniline, polythiophene, polypyrrole, or polyethylenedioxythiophene. The first electrode 11 and second electrode 15 can even be a laminated substance which is formed by laminating indium tin oxide (or ITO) and at least one member selected from the group consisting of the metals, the inorganic electrically conducting substances and the organic electrically conducting substances. From the viewpoints, such as high electrically conducting property and transparency, the first electrode 11 and second electrode 15 are desirably made of a transparent and electrically conducting metallic oxide.

The first electrode 11 and second electrode 15 can also be made of a material which hardly makes their work functions different from one another, or can even be made of distinct materials to one another so as to make the work functions different. As set forth in Dictionary of Physics and Chemistry (5th Edition, Published by IWANAMI SHOTEN in 1998), the term, "work function," means a minimum energy required for taking out an electron from the surface of substance (such as the crystal of metal or semiconductor) to the outside. In order to generate a current quickly and greatly, the first electrode 11 and second electrode 15 are made to exhibit work functions between which the difference falls in a predetermined range. For example, the difference between the work functions is set up desirably to fall in a range of from 1 eV to 3 eV. The first electrode 11 and second electrode 12 whose work functions are made different from one another augment or build up the charge separation within the organic semiconductor 13A. The first insulator 12, and the second insulator 14 as well help a charge separate , and then covey the polarization, which has occurred within the organic semiconductor 13A, to the first electrode 11 and second electrode 15. Accordingly, a transitional potential difference arises between the first electrode 11 and the second electrode 15. Consequently, the response characteristics of a photoelectric conversion element, for instance, a time required for the organic semiconductor 13A to output a transient current after receiving a light, are enhanced more than that of its predecessors. The result is a higher light/current conversion efficiency, and a shorter light/current conversion time.

The first insulator 12 and second insulator 14 have a function of electrically storing positive holes (or simply referred to as "holes") and electrons which have been separated in the organic semiconductor 13A. The first insulator 12 is disposed to make contact with the first electrode 11, and has a first capacitance "C1." The second insulator 14 is disposed to make contact with the second electrode 15, and has a second capacitance "C2." The first insulator 12 and second insulator 14 are formed so that the first capacitance "C1" is larger than the second capacitance "C2" (namely, so that they satisfy "C1" > "C2"). Note however that in an embodiment of the invention, the second insulator 14 is formed satisfactorily of an arbitrary or discretional material, which has both insulation and electric storage properties combinedly, and is selected from a solid insulator or ionic liquid.

To the solid insulator, a fluorine-based plastic (or fluororesin) is applicable. Exemplary materials of the fluorine-based plastic are as follows: polyvinylidene difluoride (or PVDF); polyvinyl fluoride (or PVF); polytetrafluoroethyelene (or PTFE); tetrafluoroethylene-ethylene copolymers (or ETFE); tetrafluoroethyelene-hexafluoropropylene copolymers (or FEP); tetrafluoroethyelene-perfluoroalkyl-vinylether copolymers (or PFA); polychloro-trifluoroethylene (or PCTFE); and chlorotrifluoroethylene-ethyelene copolymers (or ECTFE).

In an embodiment of the invention, the first insulator layer 12 includes an ionic liquid including a positive ion and negative ion as the major components. In general, an ionic liquid exerts extremely low vapor pressures, and exhibits inflammability or noncombustibility. Since the ionic liquid is sometimes referred to as an "ordinary-temperature molten salt," many ionic liquids have a melting point which is present at around room temperature. The ionic liquid according to some of the present embodiments is preferably a liquid in the service temperature range.

The positive ion is not at all limited especially. The following are given however as some of the examples applicable to the positive ion: a cation of nitrogen-containing compound; a quaternary phosphonium cation; or a sulfonium cation. For example, the following are applicable to the cation of nitrogen-containing compound: a heterocyclic aromatic cation, such as an imidazolium cation or pyridinium cation; a heterocyclic aliphatic cation, such as a piperidinium cation, pyrrolidinium cation, pyrazolium cation, thiazolium cation or morpholinium cation; a quaternary ammonium cation; or a cation with a form to which an aromatic amine, aliphatic amine or alicyclic amine is added.

The negative ion is not at all limited especially. The following are given however as some of the examples applicable to the negative ion: a halide anion, such as Cl⁻, Br⁻ or I⁻; a boride anion, such as BF₄⁻, B(CN)₄⁻ or B(C₂O₄)₂⁻; an amide anion or imide anion, such as (CN)₂N⁻, [N(SO₂F)₂]⁻, [N(SO₂CF₃)₂]⁻ or [N(SO₂C₂F₅)₂]⁻; a sulfate anion or sulfonate anion, such as RSO₃⁻ (where "R" expresses an aliphatic hydrocarbon group or aromatic hydrocarbon group, and will signify the same hereinafter), RSO₄⁻, RfSO₃⁻ (where "Rf" expresses a fluorine-containing halogenated hydrocarbon group, and will signify the same hereinafter) or RfSO₄⁻; a phosphate anion, such as Rf₂P(O)O⁻, PF₆⁻ or Rf₃P₃⁻; an antimony anion, such as SbF₆⁻. In addition to the above, other various negative ions, such as lactate, a nitrate ion or trifluoroacetate, are also applicable to the negative ion.

The ionic liquid also comprises satisfactorily a combination of a cation and anion, each of which is one member selected from the group consisting of the above-described cations and anions. Moreover, the ionic liquid even comprises properly a cation and anion, one of which or both of which are two or more members selected from the group consisting of the above-described cations, and which coexist mixedly therein.

The organic semiconductor 13A is an example of the organic semiconductor 13. The organic semiconductor 13A is interposed between the first insulator 12 and the second insulator 14 to make contact with them, and has a function of receiving a light, which a light source sheds or casts, to generate an electromotive force by separating a charge. As far as the organic semiconductor 13A has the function, it comprises satisfactorily an n-type organic semiconductor, a p-type organic semiconductor, or an amphoteric semiconductor, or comprises properly a multi - laminated film or mixture of the semiconductors. The light source is an arbitrary or discretionary constituent which satisfactorily sheds or casts a light, like sunlight, including light components with multiple wavelengths, or which properly sheds or casts a light, like a laser light or LED light, including a light component with a single wave length. However, the light is needed to exhibit a modulated light or optical intensity. For example, the following are applicable to a light which the light source sheds or casts: pulsed lights, chopped lights, and modulated lights or radiations which are used for light or optical signal.

The n-type organic conductor is an acceptor organic semiconductor, and is an organic compound that is represented mainly by electron transporting organic compounds, and which is provided with such a property that it is likely to accept electrons. To be concrete, it is one of the two organic compounds that make contact with one another to be used, and one of which exhibits a larger electron affinity than that of the other.

To the acceptor organic semiconductor, an arbitrary or discretionary organic compound is applied satisfactorily as far as it is an organic compound having an electron-accepting property. Some of the applicable examples are as follows: fullerenes selected from the group0 consisting of fullerene and fullerene derivatives; heterocyclic compounds containing nitrogen atom, oxygen atom or sulfur atom; polyarylene compounds; fluorene compounds; cyclopentadiene compounds; and silyl compounds. The acceptor organic semiconductor even comprises satisfactorily a metallic complex including a nitrogen-containing heterocyclic compound as one of the ligands.

The following are some of the examples applicable to the above-described heterocyclic compounds: pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzoxazole, benzothiazole, carbazole, purine, triazolopyridazine, triazolopyrimidine, tetrazaindene, oxadiazole, imidazopyridine, pyrrolidine, pyrrolopyridine, thiadiazolopyridine, dibenzazepine, and tribenzazepine.

The p-type organic semiconductor is a donor organic semiconductor, and is an organic compound that is represented mainly by hole transporting organic compounds, and which is provided with such a property that it is likely to donate electrons. To be concrete, it is one of the two organic compounds that make contact with one another to be used, and one of which exhibits a smaller ionization potential than that of the other.

To the donor organic semiconductor, an arbitrary or discretionary organic compound is applied satisfactorily as far as it is an organic compound having an electron donating property. Some of the applicable examples are as follows: triaryl amine compounds; benzidine compounds; pyrazoline compounds; styryl amine compounds; hydrazone compounds; triphenylmethane compounds; carbazole compounds; polysilane compounds; thiophene compounds; phthalocyanine compounds; subphthalocyanine compounds; quinacridone compounds; porphyrin compounds; cyanine compounds; merocyanine compounds; oxonol compounds; polyamine compounds; indole compounds; pyrrole compounds; diketo-pyrrolo-pyrrole compounds; pyrazole compounds; polyarylene compounds; condensed aromatic cyclic hydrocarbon compounds; homopolymers, such as polythiophene, polyfluorene and polypyrole; and donor/accepter-type copolymers. The donor organic semiconductor even comprises satisfactorily a metallic complex including a nitrogen-containing heterocyclic compound as one of the ligands.

The following are some of the examples applicable to the above-described condensed aromatic cyclic hydrocarbon compounds: naphthalene derivatives, anthracene derivatives, phenanthrene derivatives, tetracene derivatives, pyrene derivatives, perylene derivatives, and fluoranthene derivatives.

The amphoteric organic semiconductor is also called as a bipolar organic semiconductor, and shows the characteristics of both n-type organic semiconductor and p-type organic semiconductor. For example, bis(4-dimethylaminodithiobenzil) nickel (II), or 1,3,6,8-tetraphenylpyrene, and the like, is applicable to the amphoteric organic semiconductor.

The first insulator 12, which is interposed between the first electrode 11 and the organic semiconductor 13A, and the second insulator 14, which is interposed between the organic semiconductor 13A and the second electrode 15, keep a dark current from generating as less as possible, even if a pin hole should have occurred during a manufacturing process of the photoelectric conversion element 10A. It is because the first insulator 12 and second insulator 14 inhibit both of the positive holes and electrons from moving, even if a charge, which is separated at the organic semiconductor 13A, tries to move toward one of the first electrode 11 and second electrode 14.

The photoelectric conversion element 10A is manufactured arbitrarily or discretionarily. For example, the photoelectric conversion element 10A, which has a structure illustrated in Fig. 1, is satisfactorily fabricated in turn from the left side, namely, from the first electrode 11, to the right side; or is satisfactorily fabricated in turn from the right side, namely, from the second electrode 15, to the left side. These fabrication methods mentioned herein do not damage the organic semiconductor 13A at all, because they are free of a step of vapor depositing the organic semiconductor 13A onto the first electrode 11 or second electrode 15.

The principle how the photoelectric conversion element 10A constructed as described above operates will be hereinafter described with reference to Fig. 2. As illustrated in Fig. 2, the first insulator 12 has a thickness "T1" for securing the first capacitance "C1." The organic semiconductor 13A has a thickness "T2." The second insulator 14 has a thickness "T3" for securing the second capacitance "C2."

The first capacitance "C1," and the second capacitance "C2" are made to satisfy an inequality, namely, "C1" > "C2." The second insulator 14 has the second capacitance "C2," namely, a smaller capacitance, to bring about a high-speed response. Accordingly, the second insulator 14 desirably has the thickness "T3" that is made thick adequately in order to give the second insulator 14 an insulating property sufficiently. For example, the thickness "T3" falls desirably in a range of from 50 nm to 1,000 nm. Moreover, the first insulator 12 has the first capacitance "C1," namely, a larger capacitance, to bring about a large current. Accordingly, the first insulator 12 desirably has the thickness "T1" that is made thin adequately in order to make the first capacitance "C1" larger when the first insulator 12, in a non-inventive example, is made up of a solid dielectric substance or ferroelectric substance. For example, the thickness "T1" falls desirably in a range of from 10 nm to 200 nm. Note that, when the first insulator 12 is made of an electrolyte like an ionic liquid, the thickness "T1" falls satisfactorily in a range of from 10 nm to 1 mm, because the formation of solid-liquid interface electric double layer does not depend on the thickness "T1" at all.

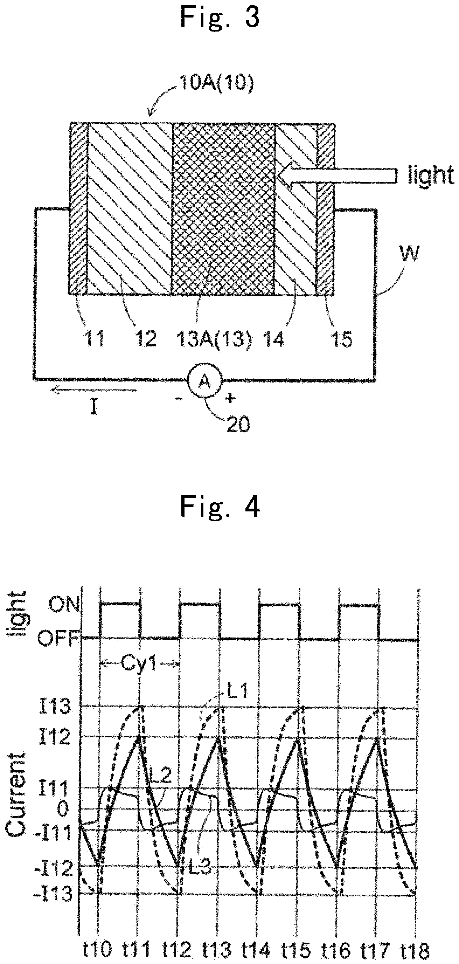

The light is shed or cast satisfactorily onto the organic semiconductor 13A from any of directions as far as the irradiated organic semiconductor 13A is excited. The shedding or casting directions shown by the graphic arrows in Figs. 2 and 3 are just one of the examples. The light according to the present embodiment mode is arbitrary or discretionary as far as being one of lights used for optical communication. For example, infrared or visible rays are applicable to the light.

The organic semiconductor 13A, which receives the light, undergoes an energy excited state so that the charge is separated therein, as illustrated in Fig. 2. That is, the charge is separated into the positive holes illustrated with δ ⁺ and electrons illustrated with δ so that a polarization arises in the organic semiconductor 13A. The resulting polarization then polarizes the first insulator 12 and second insulator 14. The polarizations occurred in the first insulator 12 and second insulator 14 are transmitted to an external circuit (i.e., to the conducting wiring "W" illustrated in Fig.2) to yield a polarization current. When the shedding or casting of the light is turned off, the polarizations are canceled so that another current flows in the external circuit in another direction which is opposite to that of the polarization current flowing when the light is being shed or cast.

When the light illuminates the second electrode 15, the first insulator 12 and second insulator 14 electrically store electrons which are separated at the organic semiconductor 13A. When the light does not illuminate the second electrode 15, the first insulator 12 and second insulator 14 electrically discharge the stored electrons. The first insulator 12 having the larger capacitance facilitates the charge separation within the organic semiconductor 13A to securely enlarge the current intensity of a transient current flowing in the conducting wiring "W." On the other hand, the second insulator 14 having the smaller capacitance makes the response speed of a current flowing in the conducting wiring "W" greater securely. Hence, the photoelectric conversion element 10A makes the current intensity and response speed compatible with one another.

Next, operations of the photoelectric conversion element 10A, which is repetitively illuminated by the light and then is not illuminated by it, will be hereinafter described with reference to Figs. 3 and 4. As illustrated in Fig. 3, a gauging circuit comprises an ammeter 20 interposed between the first electrode 11 and the second electrode 15 for the purpose of measuring characteristics of the photoelectric conversion element 10A. The ammeter 20 includes a conducting wiring "W" connecting between the first electrode 11 and the second electrode 15, and gauges a current "I" flowing in the conducting wiring "W."

The photoelectric conversion element 10A, which served as one of the constituents of the gauging circuit illustrated in Fig. 3, was constructed was described below. The second electrode 15 was made using indium tin oxide (or ITO) glass. The second insulator 14 was made using a polymethylmethacrylate (or PMMA) resin, and had a thickness of 200 nm. The organic semiconductor 13A was made using Sn(II) naphthalocyanine, and had a thickness of 70 nm. In a non-inventive example the first insulator 12 was made of a solid insulator, was made using polyvinylidene difluoride (or PVDF), and had a thickness of 400 nm. In an inventive example the first insulator 12 was made of an ionic liquid, was made using TMPA-TFSI, and had a thickness of 100 *µ*m. The terms, "TMPA," is an abbreviation of trimethylammonium, and the term, "TFSI," is an abbreviation of trifluoromethanesulfonimide whose chemical formula is [N(SO₂CF₃)₂]⁻. The first electrode 11 was made using silver. The photoelectric conversion element 10A was illuminated by a light from the side of the second electrode 15. Accordingly, the second electrode 15 made a cathode.

In Fig. 4, the upper half shows a temporal change of the shed or cast light, and the lower half shows temporal changes of the current "I" flowing in the conductive wiring "W." At the upper half, the designation "ON" signifies that the light is shed or cast, and the designation "OFF" signifies that the light is not shed or cast. That is, the photoelectric conversion element 10A was illuminated by the light from a time "t10" to a time "t11," from a time "t12" to a time "t13," from a time "t14" to a time "t15," and from a time "t16" to a time "t17," respectively. A cycle "Cy1" signifies a repetitive interval that took for shedding or casting the light and not shedding or casting it. In the present embodiment, 500 nanoseconds (i.e., 2 MHz expressed in the frequency) are applied to the cycle "Cy1" as an example .

At the lower half in Fig. 4, a dashed-line characteristic curve "L1" shows characteristics of the photoelectric conversion element 10A in which the ionic liquid was applied to the first insulator 12. Moreover, a bold-continuous-line characteristic curve "L2" shows characteristics of a comparative example to which a photoelectric conversion element disclosed in Patent Literature No. 1, for instance, was applied. In addition, a thin-continuous-line characteristic curve "L3" shows characteristics of another comparative example in which a solid insulator was applied to the photoelectric conversion element disclosed in Patent Literature No. 1.

The characteristic curves "L1" and "L2" are identical with one another in that the current "I" flowed in a certain direction (e.g., in the direction of the current "I" shown in Fig. 3) within the cycle "Cy1" when the photoelectric conversion elements were illuminated by the light, and in that the current "I" flowed in the opposite direction (e.g., in the opposite direction to that of the current "I" shown in Fig. 3) when they were not illuminated by the light. Under the circumstances, the electric storage and discharge of the electrons occurred repeatedly for every half cycle of the cycle "Cy1. " Note that the characteristic curve "L1" rose up more sharply than the characteristic curve "L2" did. That is, the photoelectric conversion element 10A according to the present embodiment exhibited a faster response speed to the illumination and non-illumination by the light than did the comparative example, one of the conventional predecessors.

Moreover, the characteristic curves "L1" and "L3" indicate that the current intensity was saturated within the half cycle because the current increased fast as shown in Fig. 3. As illustrated in the drawing, the characteristic curve "L1" exhibited a maximum current that was | I13| in absolute value, and the characteristic curve "L3" exhibited a maximum current that was | I11| in absolute value. Since the two absolute values apparently satisfied an inequality, | I13| > | I11| , the photoelectric conversion element 10A according to the present embodiment securely exhibited a current intensity that was equal to or more than that of the other comparative example, another one of the conventional predecessors.

Note that Fig. 4 illustrates the characteristics of the photoelectric conversion element 10A which was illuminated by the light and then was not illuminated by it at a frequency of 2 MHz. Although the drawing does not illustrate the following at all, the same characteristics as those illustrated in the drawing were also obtained by the photoelectric conversion element 10A which was illuminated by the light and was then not illuminated by it at a frequency up to 10 GHz.

### (Second Embodiment)

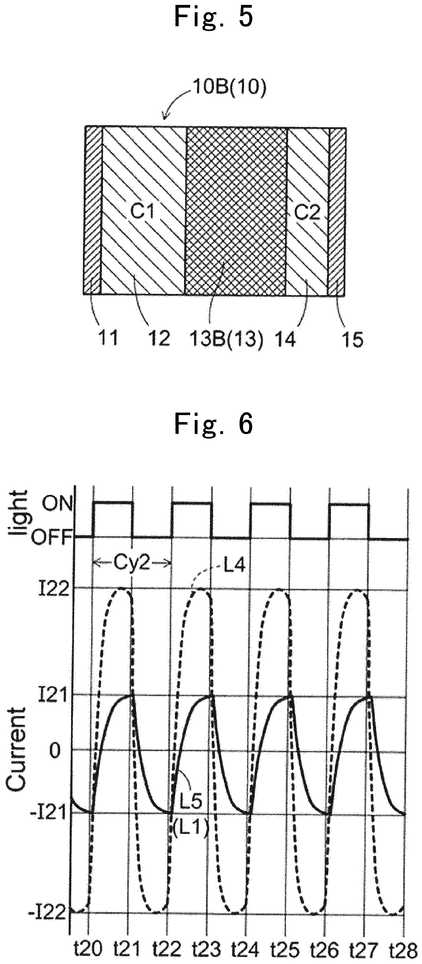

A photoelectric conversion element 10B according to Second Embodiment of the present invention will be hereinafter described with reference to Figs. 5 and 6. Note that, in order to concisely illustrate and describe Second Embodiment, descriptions on the same constituents as those employed in First Embodiment will be omitted by designating them with identical reference numerals or symbols unless specified otherwise explicitly. Hence, descriptions on Second Embodiment will be hereinafter provided mainly regarding only the features that are distinct from those of First Embodiment.

The photoelectric conversion element 10B illustrated in Fig. 5 is one of the examples of the photoelectric conversion element 10. The photoelectric conversion element 10B comprises the first electrode 11, the first insulator 12, an organic semiconductor 13B, the second insulator 14, and the second electrode 15. The photoelectric conversion element 10B differs from the photoelectric conversion element 10A in that the organic semiconductor 13B is used instead of the organic semiconductor 13A.

The organic semiconductor 13B is one of the examples of the organic semiconductor 13. The organic semiconductor 13B is interposed between the first insulator 12 and the second insulator 14 to make contact with them, and has a function of receiving a light, which an external light source sheds or casts, to separate a charge in the manner as the organic semiconductor 13A. The organic semiconductor 13B differs from the organic semiconductor 13A in that it includes a fine-particle-shaped electric conductor intermingled or intermixed therein in a predetermined proportion.

To the fine-particle-shaped electric conductor, any of the following is applied, for instance: metals, electrically-conductive resins (or referred to as "electrically-conductive plastics" as well), and nanometer-size conducting substances. The metals involve copper, silver, and aluminum. The electrically-conductive resins involve polyacethylene, polypyrrole, polythiophene, and polyaniline. The nanometer-size conducting substances involve nanotube, graphene, and nanocarbon. The predetermined proportion is set up preferably in such a range as the electric conductor does not at all hinder the photoexcitation of the organic semiconductor 13B while decreasing the electric resistance of the organic semiconductor 13B to enhance the response characteristics; and moreover as the electric conductor does not at all shield the organic semiconductor 13B electromagnetically. For example, an applicable predetermined proportion is to intermingle or intermix the electric conductor in the organic semiconductor 13B in a proportion of 50% by volume or less.

Next, how the photoelectric conversion element 10B, which is illuminated by the light and then is not illuminated by it repetitively, operates will be hereinafter described with reference to Fig. 6. Note that a gauging circuit according to Second Embodiment is constructed in the same manner as that of the gauging circuit illustrated in Fig. 3. That is, the gauging circuit comprises the conducting wiring "W" connecting between the first electrode 11 and the second electrode 15, and the ammeter 20 interposed between the first electrode 11 and the second electrode 15 to gauge the current "I" resulting from the organic semiconductor 13B to flow in the conducting wiring "W."

As illustrated in Fig. 5, the photoelectric conversionelement 10B, which was used in the gauging circuit, was constructed as described below. The second electrode 15 was made using indium tin oxide (or ITO) glass. The second insulator 14 was made using a polymethylmethacrylate (or PMMA) resin, and had a thickness of 200 nm. The organic semiconductor 13B was made using Sn(II) naphthalocyanine, and had a thickness of 70 nm. Moreover, the organic semiconductor 13B further included gold fine particles serving as an electric conductor. Note that, in the organic semiconductor 13B, the gold fine particles were intermingled or intermixed in the Sn(II) naphthalocyanine in such a ratio (or the claimed "predetermined proportion") as the Sn(II) naphthalocyanine : the gold fine particles = 1 to 10 by volume . The first insulator 12 was made using an ionic liquid which included TMPA-TFSI, and had a thickness of 100 *µ*m. The first electrode 11 was made using silver. The photoelectric conversion element 10B was illuminated by a light from the side of the second electrode 15. Accordingly, the second electrode 15 made a cathode.

In Fig. 6, the upper half shows a temporal change of the shed or cast light, and the lower half shows temporal changes of the current "I" flowing in the conductive wiring "W" in the same manner as Fig. 4. The photoelectric conversion element 10B was illuminated by the light from a time "t20" to a time "t21," from a time "t22" to a time "t23," from a time "t24" to a time "t25," and from a time "t26" to a time "t27," respectively. The same cycle as applied to the cycle "Cy1" shown in Fig. 4, namely, 500 nanoseconds (i.e., 2 MHz expressed in the frequency) were applied to a cycle "Cy2."

At the lower half in Fig. 6, a dashed-line characteristic curve "L4" shows characteristics of the photoelectric conversion element 10B in which the fine-particle-shaped electric conductor was intermingled or intermixed in the organic semiconductor 13B. For reference, a continuous-line characteristic curve "L5" shows characteristics of a photoelectric conversion element which was free from the fine-particle-shaped electric conductor intermingled or intermixed in the organic semiconductor 13B, namely, those of the photoelectric conversion element 10A. That is, the characteristic curve "L5" corresponds to the characteristic curve "L1."

The characteristic curves "L4" and "L5" are identical with one another in that the current "I" flowed in a certain direction (e.g., in the direction of the current "I" shown in Fig. 3) within the cycle "Cy2" when the photoelectric conversion elements were illuminated by the light, and in that the current "I" flowed in the opposite direction (e.g., in the opposite direction to that of the current "I" shown in Fig. 3) when they were not illuminated by the light. Under the circumstances, the photoelectric conversion elements 10A and 10B completed the electric storage and discharge of the electrons within the half cycle of the cycle "Cy2," respectively, but the photoelectric conversion element 10B exhibited the characteristic curve "L4" which rose up faster than the characteristic curve "L5" did. Thus, the photoelectric conversion element 10B provided a further enhanced response speed to the illumination and non-illumination by the light.

Comparing the characteristic curve "L4" with the characteristic curve "L5," the photoelectric conversion element 10B was found to exhibit a current intensity that rose faster than that of the photoelectric conversion element 10A. The advantage was produced by the electric conductor which was intermingled or intermixed with the organic semiconductor 13B to decrease the electric resistance of the entire circuit. As illustrated in Fig. 6, the results were the characteristic curve "L4" exhibiting a maximum current that was | I22| in absolute value; and the characteristic curve "L5" exhibiting a maximum current that was | I21| in absolute value; wherein the two absolute values apparently satisfied an inequality, | I22| > | I21 |.

Note that Fig. 6 illustrates the characteristics of the photoelectric conversion element 10B which was illuminated by the light and then was not illuminated by it at a frequency of 2 MHz. Although Fig. 6 does not illustrate the following at all, the photoelectric conversion element 10B, which was illuminated by the light and then was not illuminated by it at a frequency up to 10 GHz, produced the same characteristics as those shown by the characteristic curve "L4" in the drawing.

### (Other Embodiments)

Although modes for executing or implementing the present invention have been described so far in accordance with First and Second Embodiments, the present invention is not at all limited to the embodiments. In other words, the present invention is executed or implemented variously in other modes within a range not departing from the gist or spirit of the present invention. For example, the present invention is materialized satisfactorily by each of modes described below.

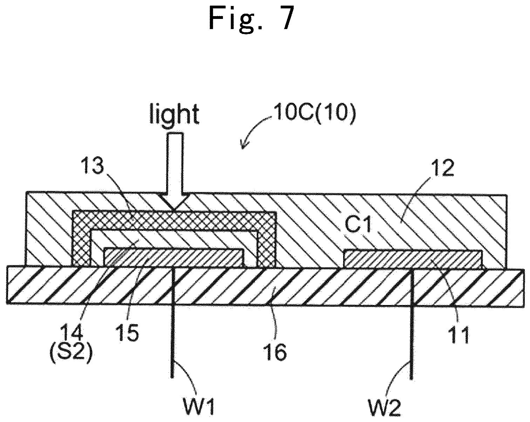

In First and Second Embodiments described above, the organic semiconductor 13 is sandwiched by the first insulator 12 and second insulator 14 to construct the photoelectric conversion element 10 (see Figs. 1 and 5). Instead of the embodiments, the photoelectric conversion element 10 may also be constructed as another structure. The other structure is constructed other than the sandwiched structure, and is applied to a photoelectric conversion element 10C as illustrated in Fig. 7, for instance. The photoelectric conversion element 10C comprises the first electrode 11, the first insulator 12, the organic semiconductor 13, the second insulator 15 and the second electrode 14, all of which are arranged on a substrate 16. The second insulator 14 is disposed to make contact with the second electrode 15 so as to cover it. The organic semiconductor 13 is disposed to make contact with the second insulator 14 so as to cover it. The first insulator 12 is disposed to make contact with the organic semiconductor 13 and first electrode 11 so as to cover them. The second electrode 15 is connected with a conductive wire "W1." The first electrode 11 is connected with a conductive wire "W2." Since the conductive wires "W1" and "W2" are disposed to an output electric signal, it does not matter whether they penetrate thorough the substrate 16 or not. Although the drawing does not depict the following explicitly, the constituents, namely, the first electrode 11, first insulator 12, organic semiconductor 13, second insulator 14 and second electrode 15, do not necessarily have a cross-sectional configuration that the drawing illustrates. The constituents can have any geometric configuration involving circular configurations and polygonal configurations. In whatever configuration the constituents are shaped, the first electrode 11 is made to be in contact with the first insulator 12; the second insulator 14 is made to be in contact with the second electrode 15; and the organic semiconductor 13 is made to intervene between the first insulator 12 and the second insulator 14 to be in contact with them. Therefore, the photoelectric conversion element 10, which is constructed to have any structure, operates and produces advantageous effects in the same manner as First and Second Embodiments do.

Above-described First and Second Embodiments comprise an ionic liquid which is applied to the first insulator 12. The ionic liquid is made to work as a liquid at ordinary or room temperature. Instead of the embodiments, a gelled ionic liquid is applied satisfactorily to the first insulator 12 in order to prevent the ionic liquid from leaking. In addition to the ionic liquids described above, the following may also be applied to the first insulator 12: polyoxometalates, ionic conductors, and protonicconductors. A "polyoxometalate" is a molecule whose chemical formula is expressed by [MₓO_{y}]ⁿ⁻ (where "M" is at least one member selected from the group consisting of Mo, V, W, Ti, Al and Nb, for instance), and is a condensed oxyacid, which is generated by condensing an oxyacid made of an earlier-cycle transition metal element belonging to a group other than Group 3, (i.e., an anionic metallic polynuclear oxygen complex). The ionic conductor is a conductor in which the displacement of ions makes a charge. The protonic conductor is a conductor in which protons (e.g., hydrogen ions) function as the most dominant charge carrier within the crystal. Whichever one of the aforementioned materials is applied to the first insulator 12, an electric double layer is formed readily at the interface between a solid and a liquid. Accordingly, positive holes and electrons, which result from a charge, are donated and accepted securely. Consequently, the first insulator 12 modified as described above provides the same operations and advantageous effects as the first insulator 12 according to First and Second Embodiments does .

Above-described First and Second Embodiments are constructed by applying the organic semiconductor 13, which comprises an n-type organic semiconductor or p-type organic semiconductor, to a charge separating member, which separates a charge into positive holes and electrons (see Figs. 1 and 5). Instead of the embodiments, another semiconductor may be applied to construct the organic semiconductor 13. The other semiconductor is formed using the following: a donor (or electron donor) or acceptor (or electron acceptor) having an absorption band in a specific wavelength range; a charge-transfer complex comprising a compound of a donor and acceptor which has a charge - transfer absorption band in a specific wavelength range; or a mixture of a donor and acceptor. That is, the other semiconductor includes satisfactorily any one of the following: a) a donor having an absorption band in a specific wavelength range; b) an acceptor having an absorption band in a specific wavelength range; c) a charge-transfer complex comprising a compound of a donor and acceptor which has a charge-transfer absorption band in a specific wavelength range; and d) a mixture of a donor and acceptor which are given in above a) through c). In short, the other semiconductor is an arbitrary or discretionary charge separating member or material which is capable of separating a charge into positive holes and electrons when being illuminated by a light. The thus constructed organic semiconductor 13, which is formed of a substance having an absorption band in a specific wavelength range, separates a charge in compliance with the wavelength of a light to be shed or cast. Therefore, the organic semiconductor 13 modified as described above provides the same operations and advantageous effects as the organic semiconductors 13A and 13B according to First and Second Embodiments do.

### (Operations and Advantageous Effects)

Above-described First and Second Embodiments, as well as the other embodiments, produce advantageous effects as described below, respectively.
(1) As illustrated in Figs. 1 and 5, the photoelectric conversion element 10 (e.g., 10A or 10B) is constructed to comprise: the first insulator 12 having the first capacitance "C1," and disposed to make contact with the first electrode 11; the second insulator 14 having the second capacitance "C2," which is smaller than the first capacitance "C1" of the first insulator 12, and disposed to make contact with the second electrode 15; and the organic semiconductor 13 interposed between the first insulator 12 and the second insulator 14 to make contact with them. The thus constructed photoelectric conversion element 10 enlarges the current "I" because the first insulator 12 has a larger capacitance, namely, the first capacitance "C1," so that the polarized first insulator 12 facilitates the charge separation in the intermediate layer of the organic semiconductor 13. Moreover, the photoelectric conversion element 10 exhibits enhanced response characteristics because the second insulator 14 has a smaller capacitance, namely, the second capacitance "C2," so that it makes the current "I" likely to flow in the external circuit. Therefore, the photoelectric conversion element 10 is upgraded more in both of the current intensity and response speed than those of the conventional predecessors. In addition, the first insulator 12, which is interposed between the first electrode 11 and the organic semiconductor 13, and the second insulator 14, which is interposed between the organic semiconductor 13 and the second electrode 15, suppress the occurrence of dark current even if a pin hole should have arisen during a process or step of manufacturing the photoelectric conversion element 10.
(2) The first insulator 12 is constructed to include an ionic liquid whose major components are a positive ion and negative ion, or a solid insulator shaped by a predetermined insulating material. Whichever one of the ionic liquid and solid insulator the thus constructed first insulator 12 includes, the first insulator 12 has such a large capacitance that it polarizes to facilitate the charge separation in the intermediate layer of the organic semiconductor 13. Accordingly, the first insulator 12 makes the current "I" greater. Consequently, the first insulator 12 provides the photoelectric conversion element 10 yielding a current intensity which is upgraded securely to be better than that of the conventional predecessors.
(3) The organic semiconductor 13B is constructed to include a fine-particle-shaped electric conductor intermingled or intermixed in a predetermined proportion (see Fig. 5). The thus constructed organic semiconductor 13B is decreased in the electric resistance and is enhanced in the responsive characteristics by the intermingled or intermixed fine-particle-shaped electric conductor. Therefore, the organic semiconductor 13B provides the photoelectric conversion element 10 yielding a further upgraded current intensity.
(4) The light is constructed to be at least one member selected from the group consisting of pulsed lights, chopped lights and modulated lights or radiations. The photoelectric conversion element 10 constructed as described above yields a strengthened current intensity and quickened response speed to a light whose light intensity is modulated.

### Industrial Applicability

A photoelectric conversion element according to the present invention has a function of receiving a light to generate an electromotive force. Parts or apparatuses, to which the present photoelectric conversion element is applicable and which make good use of the function, are as follows: light-current conversion elements, light sensors involving photodiodes, luminosity sensors, and so on. A light-current conversion element converts at an ultrafast rate a pulse of infrared beam, which propagates through an optical fiber, into a current. A luminosity sensor detects the intensity of a light.

### Explanation on Reference Numerals

10 (e.g., 10A, 10B, or 10C): Photoelectric Conversion Element;
11: First Electrode;
12: First Insulator (e.g., Ionic Liquid)
13 (e.g., 13A, or 13B): Organic Semiconductor;
14: Second Insulator (e.g., Solid Insulator) ; and
15: Second Electrode

## Claims

1. A photoelectric conversion element (10) comprising:
a pair of electrodes (11, 15) including a first electrode (11) and a second electrode (15);
a first insulator layer (12) having a first capacitance, and disposed to make contact with the first electrode (11);
a second insulator layer (14) having a second capacitance, which is smaller than the first capacitance of the first insulator layer (12), and disposed to make contact with the second electrode (15), wherein the second insulator layer is a solid insulator or an ionic liquid; and
an organic semiconductor (13, 13A, 13B) configured to receive a light to generate an electromotive force, and interposed between the first insulator layer (12) and the second insulator layer (14) to make contact therewith,
**characterized in that** the first insulator layer (12) includes an ionic liquid whose major components are a positive ion and a negative ion.

2. The photoelectric conversion element (10) as set forth in claim 1, wherein the second insulator layer (14) includes an ionic liquid whose major components are a positive ion and a negative ion.

3. The photoelectric conversion element (10) as set forth in claim 1 or 2, wherein the organic semiconductor (13, 13A, 13B) includes a fine-particle-shaped electric conductor intermixed in a predetermined proportion.

4. The photoelectric conversion element (10) as set forth in any one of claims 1 through 3, wherein the light is at least one member selected from the group consisting of pulsed lights, chopped lights and modulated lights.

## Patentansprüche

1. Photoelektrisches Umwandlungsbauelement (10), mit:
einem Paar von Elektroden (11, 15), das eine erste Elektrode (11) und eine zweite Elektrode (15) umfasst;
einer ersten Isolationsschicht (12), die eine erste Kapazität aufweist und derart angeordnet ist, dass sie einen Kontakt mit der ersten Elektrode (11) herstellt;
einer zweiten Isolationsschicht (14), die eine zweite Kapazität aufweist, die kleiner als die erste Kapazität der ersten Isolationsschicht (12) ist, und die derart angeordnet ist, dass sie einen Kontakt mit der zweiten Elektrode (15) herstellt, wobei die zweite Isolationsschicht ein Feststoffisolator oder eine ionische Flüssigkeit ist; und
einem organischen Halbleiter (13, 13A, 13B), der dazu eingerichtet ist, ein Licht zur Erzeugung einer elektromotorischen Kraft zu empfangen, und der zwischen der ersten Isolationsschicht (12) und der zweiten Isolationsschicht (14) eingebracht ist, um einen Kontakt zu diesen herzustellen,
**dadurch gekennzeichnet, dass**
die erste Isolationsschicht (12) eine ionische Flüssigkeit umfasst, deren Hauptkomponenten ein positives Ion und ein negatives Ion sind.

2. Photoelektrisches Umwandlungsbauelement (10) nach Anspruch 1, wobei die zweite Isolationsschicht (14) eine ionische Flüssigkeit umfasst, deren Hauptkomponenten ein positives Ion und ein negatives Ion sind.

3. Photoelektrisches Umwandlungsbauelement (10) nach Anspruch 1 oder 2, wobei der organische Halbleiter (13, 13A, 13B) einen in einem vorbestimmten Anteil eingemischten feinpartikelförmigen elektrischen Leiter umfasst.

4. Photoelektrisches Umwandlungsbauelement (10) nach einem der Ansprüche 1 bis 3, wobei das Licht zumindest ein Element ist, das aus der Gruppe ausgewählt ist, die aus gepulstem Licht, zerhacktem Licht und moduliertem Licht besteht.

## Revendications

1. Elément de conversion photoélectrique (10) comprenant :
une paire d'électrodes (11, 15) comprenant une première électrode (11) et une deuxième électrode (15) ;
une première couche d'isolant (12) ayant une première capacitance, et disposée de façon à faire contact avec la première électrode (11) ;
une deuxième couche d'isolant (14) ayant une deuxième capacitance, qui est inférieure à la première capacitance de la première couche d'isolant (12), et disposée de façon à faire contact avec la deuxième électrode (15), laquelle deuxième couche d'isolant est un isolant solide ou un liquide ionique ; et
un semi-conducteur organique (13, 13A, 13B) configuré pour recevoir une lumière pour générer une force électromotrice, et interposé entre la première couche d'isolant (12) et la deuxième couche d'isolant (14) pour faire contact avec elles,
**caractérisé en ce que** la première couche d'isolant (12) comprend un liquide ionique dont les composants majeurs sont un ion positif et un ion négatif.

2. Elément de conversion photoélectrique (10) selon la revendication 1, dans lequel la deuxième couche d'isolant (14) comprend un liquide ionique dont les composants majeurs sont un ion positif et un ion négatif.

3. Elément de conversion photoélectrique (10) selon la revendication 1 ou 2, dans lequel le semi-conducteur organique (13, 13A, 13B) comprend un conducteur électrique en forme de fines particules mélangé en une proportion prédéterminée.

4. Elément de conversion photoélectrique (10) selon l'une quelconque des revendications 1 à 3, dans lequel la lumière est au moins un membre choisi dans le groupe constitué par une lumière puisée, une lumière tronçonnée et une lumière modulée.
